# EUROPÄISCHE PATENTSCHRIFT

(11) **EP 3 212 820 B1**
(45) Veröffentlichungstag und Bekanntmachung des Hinweises auf die Patenterteilung: **12.01.2022**
(21) Anmeldenummer: 15778671.6
(22) Anmeldetag: 12.10.2015
(51) Int. Cl.: C23C 16/01, C23C 16/56, C01B 32/182, G01N 21/84, C23C 16/26, C01B 32/16, C01B 32/186, C01B 32/168, C01B 32/194

(54) **VERFAHREN ZUM TRENNEN EINER KOHLENSTOFFSTRUKTUR VON EINER KEIMSTRUKTUR**
METHOD FOR SEPARATING A CARBON STRUCTURE FROM A SEED STRUCTURE
PROCÉDÉ DE SÉPARATION D'UNE STRUCTURE DE CARBONE D'UNE STRUCTURE DE NUCLÉATION

(30) Priorität: 29.10.2014 DE 102014115708
(43) Veröffentlichungstag der Anmeldung: 06.09.2017
(73) Patentinhaber: Aixtron SE, 52134 Herzogenrath (DE)
(72) Erfinder: TEO, Kenneth B. K., Cambridge Cambridgeshire CB23 5BH (GB); JOUVRAY, Alexandre, Huntingdon Cambridgeshire PE28 9QB (GB); MATHARU, Jai, St. Albans Hertfordshire AL1 5SA (GB); THOMAS, Simon, Peterborough Cambridgeshire PE2 8AX (GB)
(74) Vertreter: Grundmann, Dirk
(86) Internationale Anmeldenummer: PCT/EP2015/073553
(87) Internationale Veröffentlichungsnummer: WO 2016/066413

(56) Entgegenhaltungen:
- WO-A1-2012/039533
- WO-A1-2014/094103
- DE-A1-102011 056 538
- JP-A- S6 479 384
- US-A1- 2011 237 051
- US-A1- 2014 147 353
- None

## Beschreibung

Die Erfindung betrifft ein Verfahren zum Trennen einer an einer Keimstruktur abgeschiedenen Kohlenstoffstruktur, beispielsweise Graphene, Carbon-Nanotubes oder Halbleiter-Nanowires von der Keimstruktur.

Es ist aus dem Stand der Technik bekannt, Kohlenstoffstrukturen, beispielsweise Graphene-Schichten, Carbon-Nanotubes und Halbleiter-Nanowires auf Substraten abzuscheiden. Ein derartiges Verfahren beschreibt unter anderem die US 8,685,843 B2. Die Abscheidung der Kohlenstoffstrukturen erfolgt dabei auf einer Keimstruktur, beispielsweise einer Metallstruktur, die eine Metallschicht, insbesondere Kupferschicht sein kann. Das Abscheide von Graphene wird auch in der US 8,728,433 B2 beschrieben. Nach dem Abscheiden der Graphene Schicht, der Carbon-Nanotubes oder der Halbleiter-Nanowires auf der Keimstruktur ist es erforderlich, Strukturen bzw. Schichten voneinander zu lösen. Dies erfolgt beim Stand der Technik durch ein Nassätzverfahren, bei dem die Keimstruktur in einer wässrigen Lösung weggeätzt wird.

Es sind zudem Verfahren bekannt, um eine Prozesskammer eines CVD-Reaktors im Trockenätzverfahren zu reinigen. Beispielsweise zeigt die WO 2014/094103 A1 ein Reinigungsverfahren zum Entfernen von III-V-Belegungen an den Wänden eines Reaktors durch Einleiten von Thionylchlorid in die Prozesskammer. Zudem ist das Trockenätzen von Metallschichten aus den Patentdokumenten JP-S-6479384 A und US 2014/0147353 A1 bekannt.

Aus WO 2012/039533 ist bekannt, eine Graphenschicht auf eine Keimschicht abzuscheiden und die Graphenschicht von der Keimschicht durch Nassätzen oder Trockenätzen zu trennen.

Der Erfindung liegt die Aufgabe zugrunde, die Herstellung von Kohlenstoffstrukturen zu vereinfachen und insbesondere ein Verfahren anzugeben, mit dem das Trennen der Kohlenstoffstruktur von der Keimstruktur innerhalb der Prozesskammer, in der die Abscheidung erfolgt, möglich ist.

Gelöst wird die Aufgabe durch die in den Ansprüchen angegebene Erfindung. Das Verfahren besteht im Wesentlichen aus den folgenden Schritten:
- Bereitstellen einer an einer Keimstruktur abgeschiedenen Kohlenstoffstruktur in einer Prozesskammer eines CVD-Reaktors;
- Aufheizen des die Keimstruktur (2) und die Kohlenstoffstruktur (1) aufweisenden Substrates auf eine Prozesstemperatur;
- Einspeisen zumindest eines Ätzgases mit der Summenformel AOₘXₙ, AOₘXₙYₚ oder AₘXₙ,
   wobei A aus einer Gruppe von Elementen ausgewählt ist, die S, C, N enthält,
   wobei O Sauerstoff ist,
   wobei X, Y verschiedene Halogene sind und
   ₘ, ₙ, ₚ natürliche Zahlen > Null sind;
- Aktivierung des Ätzgases durch Zufuhr von Wärme, durch ultraviolettes Licht oder durch Plasma innerhalb der Prozesskammer (7), so dass sich das Ätzgas in erste Reaktionsprodukte vorzerlegt;
- Umwandeln der Keimstruktur (2) durch eine chemische Reaktion mit den ersten Reaktionsprodukten des Äztgases in ein zweites gasförmiges Reaktionsprodukt;
- Entfernen des gasförmigen Reaktionsproduktes aus der Prozesskammer mittels eines Trägergasflusses.

Die Verfahrensschritte werden bevorzugt unmittelbar nach den Verfahrensschritten eines Beschichtungsverfahrens durchgeführt, bei dem auf oder unter eine Keimstruktur eine Kohlenstoffstruktur aufgebracht worden ist, wie es im eingangs genannten Stand der Technik beschrieben wird. Die dem erfindungsgemäßen Trennverfahren vorangehende katalytische Synthese von "Carbon Nanotubes" und "Carbon Nanofibers" wird unter dem Titel Catalytic Synthesis of Carbon Nanotubes and Nanofibers" in Encyclopedia of Nanoscience and Nanotechnology, Volume X: Pages 1 - 22 durch Kenneth B. K. Teo, Charanjeet Singh, Manish Chhowalla und William I. Milne beschrieben. Der Inhalt dieses Papers gehört zum Offenbarungsgehalt dieser Patentanmeldung. Die Trennung der Kohlenstoffstruktur von der Keimstruktur erfolgt bevorzugt in derselben Prozesskammer, in der auch der Abscheideprozess stattgefunden hat und ohne dass das die Kohlenstoffstruktur aufweisende Objekt aus der Prozesskammer entnommen worden ist. Bei dem die Kohlenstoffstruktur tragenden Objekt kann es sich um ein Substrat, beispielsweise um ein dielektrisches Substrat handeln, welches mit einer Keimstruktur versehen ist. Die Keimstruktur kann aus Cu, Ni, Co, Fe, Ru, Ir, Ga, Gd, Mo, Mn, Ag, Au, B, Si oder Ge oder aus einem Metall oder aber auch aus einem mehrere der vorgenannten Elemente beinhaltenden Werkstoff bestehen. Bei der Keimstruktur kann es sich um Partikel oder um eine strukturierte oder unstrukturierte Schicht auf einem Substrat handeln. Es ist insbesondere vorgesehen, dass die Keimstruktur zwischen Substrat und Kohlenstoffstruktur angeordnet ist. Ein derartiges Objekt bestehend aus Substrat, Keimstruktur und Kohlenstoffstruktur enthält eine Kohlenstoffstruktur, die auf der Keimstruktur abgeschieden worden ist. Das Objekt kann auch lediglich eine auf einer Keimstruktur abgeschiedene Kohlenstoffstruktur sein. In diesem Fall bildet die Keimstruktur das Substrat selbst. Die Keimstruktur bildet ein katalytisches Element, an dem die Nanostrukturen, also Nanotubes oder Nanowires anwachsen. Diese katalytischen Strukturen können auch von Partikeln gebildet sein, die vom Substrat getragen werden. Die Kohlenstoffstrukturen wachsen dann zwischen Substrat und den Partikeln. Erfindungsgemäß wird die Keimstruktur durch Einleiten eines Ätzgases in die Prozesskammer bei erhöhter Temperatur in die Gasform gebracht. Als Ergebnis des Ätzprozesses liegt entweder die Kohlenstoffstruktur im Wesentlichen lose auf dem Substrat oder auf einem Suszeptor auf. Das Ätzgas wird aktiviert.

Die Aktivierung des Ätzgases erfolgt durch Energiezufuhr Als Energiequelle dient eine Wärmequelle, insbesondere eine Heizung oder ein UV-Strahler oder ein Plasmagenerator Die Aktivierung erfolgt innerhalb der Prozesskammer durch Verwendung dort erzeugter Wärme, beispielsweise dadurch, dass das Ätzgas in Kontakt zu aufgeheizten Wänden der Prozesskammer tritt oder in Kontakt zu einem aufgeheizten Gas innerhalb der Prozesskammer tritt. Die Aktivierung, die insbesondere durch Erwärmung erfolgt, kann in einem Gaseinlassorgan oder innerhalb der Prozesskammer selbst stattfinden. Fernerkann vorgesehen sein, dass das Ätzgas aus zwei voneinander verschiedenen Gasen besteht. Das Ätzgas wird bevorzugt in einer Gasquelle bereit gehalten oder erzeugt. Bei der Gasquelle kann es sich um einen Flüssigkeitstank handeln, der von einem Trägergas, beispielsweise Ar, N₂ oder H₂ durchströmt wird. Das Ätzgas besteht insbesondere aus SOCl₂, SOBr₂, COCl₂, NOCl, NOBr, SOBr. Besonders bevorzugt wird als Ätzgas Thionylchlorid SOCl₂ verwendet. Als Ätzgas wird insbesondere eine in die Gasform gebrachte Flüssigkeit verwendet, die eine Karbonyl-, eine Thionyl- oder eine Nitrosylgruppe und ein Halogen, beispielsweise ein Chlorid, ein Bromid oder Iodit aufweist. Das erfindungsgemäße Verfahren wird in einer Vorrichtung durchgeführt, die ein Reaktorgehäuse aufweist, welches nach außen hin gasdicht abgeschlossen ist. Das Reaktorgehäuse kann mittels einer Pumpe evakuiert werden. Im Reaktorgehäuse befindet sich ein Gaseinlassorgan mit zumindest einer, bevorzugt aber mehreren Gasaustrittsöffnungen. Ferner befindet sich innerhalb der Prozesskammer ein Suszeptor, der aus Metall oder Graphit bestehen kann und der mit einer Heizung auf eine Prozesstemperatur zwischen 100° und mindestens 1000° aufgeheizt werden kann. Auf dem Suszeptor befinden sich Substrate, die in einem Beschichtungsprozess derart behandelt werden, dass auch Keimstrukturen auf Kohlenstoffstrukturen, beispielsweise Graphene, Nanotubes oder Halbleiter-Nanowires abgeschieden werden. Nach dem Abscheideprozess wird die Prozesskammer mit einem Inertgas gespült. Anschließend wird die Prozesskammer auf eine Reaktionstemperatur gebracht, die einer Prozesstemperatur entspricht, bei der das Ätzgas mit der Keimschicht chemisch reagiert. Diese Temperatur kann bei mindestens 800° C liegen. Sobald das auf dem Substrathalter liegende Objekt, welches die Kohlenstoffstruktur aufweist, die Prozesstemperatur erreicht hat, wird das Ätzgas, insbesondere Thionylchlorid in die Prozesskammer eingeleitet. Beispielsweise können bei 900 mbar Totaldruck 120 mmol pro Minute in die Prozesskammer eingeleitet werden. Das Ätzgas wird mittels eines Trägergases in die Prozesskammer eingeleitet und heizt sich dort auf, so dass es aktiviert wird. Bei dieser Aktivierung vorzerlegt sich das Ätzgas in erste Reaktionsprodukte.

Mit dem Ätzgas bzw. mit den daraus entstandenen Vorzerlegungsprodukten werden Keimstruktur und die Kohlenstoffstruktur voneinander getrennt. Der Ätzprozess dauert typischerweise 5 Minuten. Danach wird die Zufuhr des Ätzgases gestoppt und lediglich ein Inertgas in die Prozesskammer eingeleitet, welche zur Entnahme der Kohlenstoffstrukturen abgekühlt wird. Die Entfernung von Reaktionsprodukten bzw. des Ätzgases kann nach Beendigung des Ätzschrittes auch durch Abpumpen der Prozesskammer auf einem Vakuumdruck erfolgen. Zusätzlich zu dem oben beschriebenen Ätzgas kann in die Prozesskammer auch ein additives Gas eingeleitet werden, bei dem es sich um eine chemische Verbindung zwischen Wasserstoff oder Metall und einem Halogen handelt. In einer Variante der Erfindung besitzt die Prozesskammer Detektormittel, mit denen der Fortschritt des Umwandelns der Keimstruktur in ein gasförmiges Reaktionsprodukt kontinuierlich beobachtet werden kann. Es kann sich dabei um eine Lichtquelle handeln, die kontinuierliches oder gepulstes Licht, beispielsweise einen Lichtstrahl aussendet. Der Lichtstrahl trifft auf das Objekt, wird vom Objekt reflektiert. Der reflektierte Lichtstrahl trifft auf einen Detektor. Der Detektor misst insbesondere die Intensität des Lichtstrahles. Es wird somit der Reflektionsgrad bzw. das Reflektionsvermögen, die Reflektivität oder Reflektanz des Objektes bestimmt. Insbesondere wird mit der Detektoranordnung die zeitliche Änderung der Reflektivität ermittelt. Der Lichtstrahl durchdringt bevorzugt die Kohlenstoffstruktur und wird an der Oberfläche der Keimstruktur, also gewissermaßen an der Grenzschicht der Kohlenstoffstruktur zur Keimstruktur reflektiert. Es wird somit das sich im Zuge des Ätzprozesses ändernde Reflektionsvermögen der Oberfläche ermittelt. Zu Beginn des Ätzprozesses kann die Oberfläche eine glatte Metallschicht mit einem entsprechend hohen Reflektionsvermögen sein. Während des Ätzprozesses wird die Keimstruktur an der Oberfläche weggeätzt, so dass die Oberfläche rauer wird. Das Reflektionsvermögen der Oberfläche sinkt auf ein Minimum, um kurz vor der vollständigen Entfernung der Keimstruktur wieder anzusteigen. Nach entfernter Keimstruktur wird der Lichtstrahl an der glatten, ein hohes Reflektionsvermögen aufweisenden Oberfläche des Substrates reflektiert, welche vom Ätzgas nicht angegriffen wird. Das Ätzgas reagiert nicht mit dem Substrat. Das Erkennen dieses Ansteigens des Reflektionsvermögens nach Durchlaufen eines Minimums kann zum Abschalten der Ätzgaszuleitung verwendet werden. Ein automatisches Abschalten der Ätzgaseinspeisung erfolgt insbesondere dann, wenn das Reflektionsvermögen nach Durchlaufen eines Minimums wieder ein Maximum erreicht hat.

Für die Durchführung des beanspruchten Verfahrens nützlich ist eine Vorrichtung, in welcher eine Quelle für das Ätzgas vorgesehen ist.

Zusätzlich kann die Vorrichtung optische Detektionsmittel zur Ermittlung des Fortschritts des Trennverfahrens aufweisen, die mit einer Steuerungseinrichtung zusammenwirken, um die Zufuhr des Ätzgases abzuschalten.

Ausführungsbeispiele der Erfindung werden nachfolgend anhand beigefügter Zeichnungen erläutert. Es zeigen:
- Fig. 1: schematisch eine CVD-Reaktoranordnung eines ersten Ausführungsbeispiels;
- Fig. 2: schematisch eines CVD-Reaktoranordnung eines zweiten Ausführungsbeispiels;
- Fig. 3: schematisch ein erstes Ausführungsbeispiel des Trennverfahrens;
- Fig. 4: ein zweites Ausführungsbeispiel des Trennverfahrens;
- Fig. 5: ein drittes Ausführungsbeispiel des Trennverfahrens,
- Fig. 6: ein viertes Ausführungsbeispiel des Trennverfahrens;
- Fig. 7: eine Darstellung gemäß Fig. 6 vor dem Einleiten des Ätzgases zum Zeitpunkt to;
- Fig. 8: eine Folgedarstellung zu Fig. 7 während des Ätzprozesses zum Zeitpunkt t₁;
- Fig. 9: eine Folgedarstellung zu Fig. 8 zum Zeitpunkt t₂ und
- Fig. 10: lediglich qualitativ den zeitlichen Verlauf der Reflektivität der Grenzfläche 2' der Keimstruktur 2 zur Kohlenstoffstruktur 1 während des Ätzprozesses.

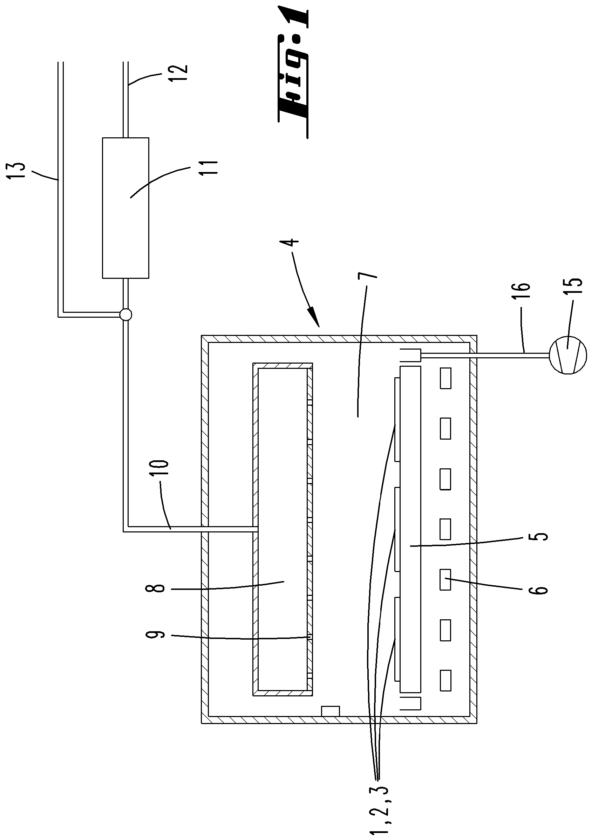

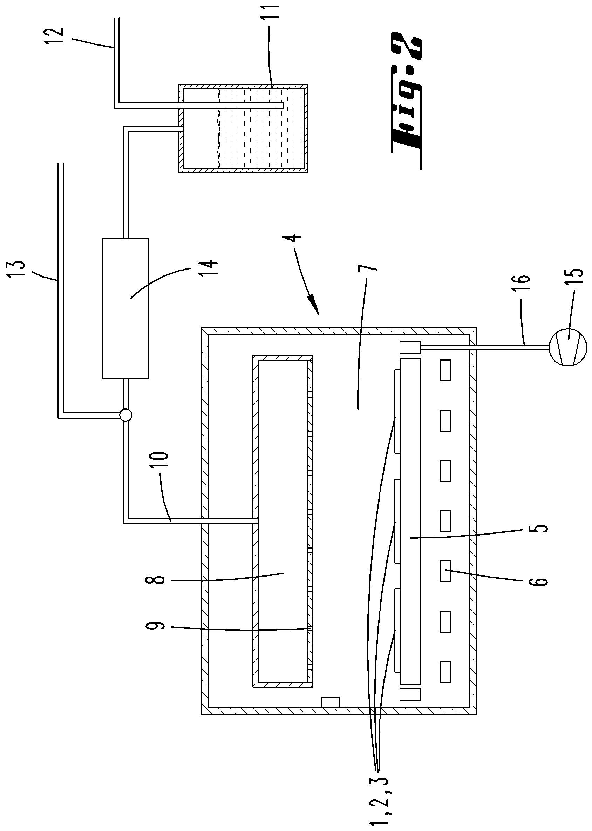

Der in den Figuren 1 und 2 dargestellte CVD-Reaktor 4 besteht aus einem Gehäuse, welches nach außen gasdicht ist. Innerhalb des Gehäuses befindet sich ein Suszeptor 5 aus Graphit, Quarz oder einem Metall zur Aufnahme von Objekten 2, 3, auf die eine Kohlenstoffstruktur 1 abgeschieden wird. Unterhalb des Suszeptors 5 befindet sich eine Heizung 6. Es kann sich um eine Widerstandsheizung, eine IR-Heizung oder um eine RF-Heizung handeln. Der kreisscheibenförmige Suszeptor 5 ist von einem Gasauslassorgan umgeben, welches mit einer Gasableitung 16 an einer Pumpe 15 angeschlossen ist. Oberhalb des Suszeptors 5 befindet sich eine Prozesskammer 7. Die Decke der Prozesskammer 7 wird von einer Gasaustrittsfläche eines Gaseinlassorganes 8 ausgebildet. Bei dem Gaseinlassorgan 8 kann es sich um einen duschkopfförmigen Hohlkörper handeln, der an seiner Unterseite eine Vielzahl von Gasaustrittsöffnungen 9 aufweist. Mit einer Zuleitung 10 kann ein Prozessgas in das Gaseinlassorgan 8 eingespeist werden.

Zur Durchführung des Verfahrens zum Abscheiden der Kohlenstoffstrukturen 1, also beispielsweise einer Graphene Schicht, einer aus mehreren Lagen bestehenden Graphene Schicht, von Carbon-Nanotubes oder von Halbleiter-Nanowires wird durch die Zuleitung 10 ein geeignetes Prozessgas, welches Kohlenstoff enthält, beispielsweise Methan in die Prozesskammer 7 eingespeist. Die darin auf dem Suszeptor 5 aufliegenden Objekte besitzen eine Keimstruktur, beispielsweise eine Keimschicht oder eine strukturierte Keimschicht 2, die aus Kupfer besteht. Auf dieser Keimstruktur 2 bilden sich die genannten Kohlenstoff-Nanostrukturen 1 aus. Die Objekte können Substrate 3 aufweisen, die mit einer Keimstruktur 2 beschichtet sind. Die Keimstruktur 2 kann eine glatte Oberfläche aufweisen. Es ist aber auch möglich, dass auf den Substraten 3 katalytisch wirkende Partikel aufliegen, die die Keimstruktur 2 ausbilden. Die Partikel haben einen Durchmesser, der im Nanometerbereich liegt. Bei der Abscheidung der Nanostrukturen bilden sich zwischen Substrat und Partikel Nanotubes oder Nanowires. Die Partikel können voneinander beabstandet sein.

Um die Kohlenstoff-Nanostrukturen 1 von den Keimstrukturen 2 zu trennen, wird ein Ätzgas verwendet. Dieses wird in einer Ätzgasquelle 11 erzeugt. Mittels eines in eine Zuleitung 12 eingespeisten Trägergases, welches ein Inertgas aus Ar, N₂ oder H2 ist, wird das Ätzgas durch die Zuleitung 10 in das Gaseinlassorgan 8 geleitet. In die Zuleitung 10 wird mittels der Zuleitung 13 zusätzlich ein weiteres Inertgas, beispielsweise Ar, N₂ oder H₂ in die Zuleitung 10 eingespeist.

Bei dem in der Figur 1 dargestellten Ausführungsbeispiel wird das Ätzgas 11 durch Erwärmen innerhalb der Prozesskammer 7 bzw. innerhalb des Gaseinlassorganes 8 aktiviert. Bei der Ätzgasquelle 11 kann es sich um einen Bubbler handeln, wie er in der Figur 2 dargestellt ist.

Bei dem in der Figur 2 dargestellten Bubbler handelt es sich um einen Behälter, in dem ein flüssiger Ausgangsstoff bevorratet ist. Bei dem Ausgangsstoff kann es sich um SOCl₂, SOBr₂, COCl₂, NOCl₂, NOBr₂ oder SOBr handeln. Bevorzugt handelt es sich bei der Flüssigkeit um Thionylchlorid. Durch Hindurchleiten eines Inertgases durch die Flüssigkeit wird ein Ätzgas erzeugt.

Bei dem in der Figur 2 dargestellten Ausführungsbeispiel ist ein externer Aktivator 14 vorgesehen, in dem das Ätzgas aktiviert wird. Dies kann durch Beaufschlagung des Ätzgases durch Wärme, durch UV oder durch ein Plasma erfolgen. In dem Aktivator 14 kann also eine Wärmequelle, eine UV-Quelle oder ein Plasmagenerator angeordnet sein.

Bei der Aktivierung des Ätzgasesfindet eine Vorzerlegung des Ätzgases statt.

Zur Durchführung des Ätzprozesses wird der Suszeptor 5 auf eine Temperatur von etwa 800° C aufgeheizt. Das vorzerlegte Ätzgas reagiert mit der Keimstruktur 2 und wandelt letztere in einen flüchtigen Ausgangsstoff um, der zusammen mit dem Trägergas aus der Ableitung 16 aus der Prozesskammer 7 entfernt wird.

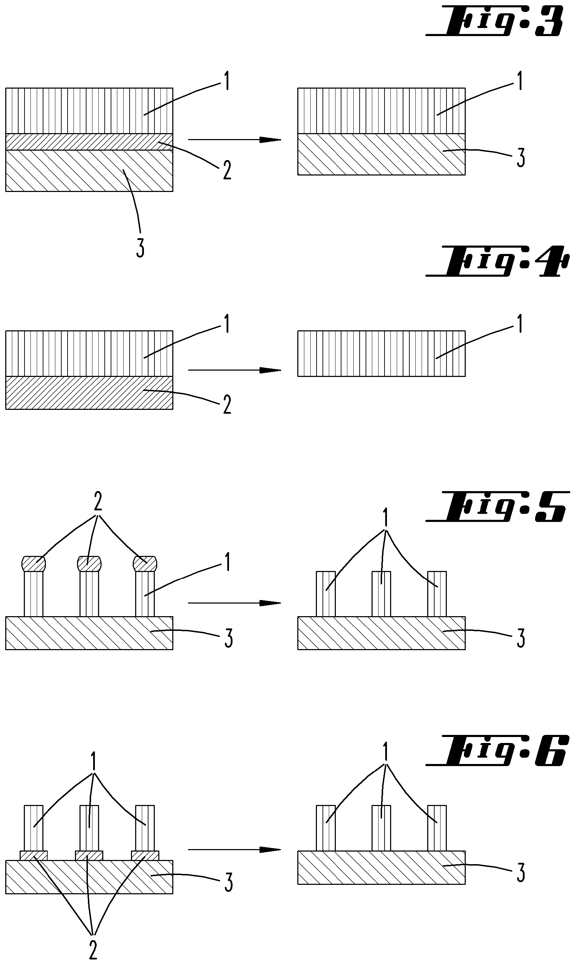

Das in der Figur 3 links dargestellte Ausführungsbeispiel zeigt ein Objekt bestehend aus einem Substrat 3, bei dem es sich um einen dielektrischen Körper handeln kann und das aus einer darauf aufgebrachten Keimstruktur 2 besteht. Die Keimstruktur 2 kann aus Kupfer bestehen und eine Schicht mit glatter Oberfläche sein. Auf der Keimstruktur 2 ist eine Graphenschicht 1 abgeschieden. Es kann sich um eine Monolage aus Graphen handeln. Es können auch wenige Graphenlagen übereinander abgeschieden sein. Bei dem oben beschriebenen Ätzprozess durchdringen erste Reaktionsprodukte des Ätzgases die Graphenschicht 1 und wandeln die Keimstruktur 2 in ein gasförmiges zweites Reaktionsprodukt um, so dass das in der Figur 3 rechts dargestellte Ergebnis entsteht, bei dem die Graphenschicht 1 unmittelbar auf dem Substrat 3 aufliegt.

Die Figur 4 zeigt links eine Graphenschicht 1, die auf einer Keimstruktur 2 abgeschieden worden ist, bei der es sich um eine Kupferplatte handelt. Die Kupferplatte 2 wird durch den Ätzprozess entfernt, so dass - wie in der Figur 4 rechts dargestellt ist - lediglich Graphen 1 verbleibt.

Bei dem in der Figur 5 dargestellten Ausführungsbeispiel unterwächst die Kohlenstoffstruktur 1, beispielsweise in Form von Nanowires oder Nanotubes eine Keimstruktur 2 aus Kupfer, die aus auf der Oberfläche des Substrates 3 aufliegenden Partikeln besteht. Zum Abscheiden derartiger Kohlenstoffstrukturen 1 werden auf ein Substrat 3 Kupferpartikel oder Partikel aus einem anderen geeigneten katalytisch wirkenden Material aufgebracht. Die Kohlenstoffstrukturen 1 wachsen dann zwischen Substrat 3 und den Partikeln. In der Figur 5 links ist eine diesbezügliche Struktur schematisch dargestellt. Nach dem Ätzprozess ist die Keimstruktur 2 entfernt, so dass - wie in der Figur 5 rechts dargestellt ist - die Nanotubes 1 bzw. Nanowires unmittelbar auf dem Substrat 3 aufliegen.

Bei dem in der Figur 6 dargestellten Ausführungsbeispiel ist links ein Objekt dargestellt, bei dem ein Substrat 3 eine lateral strukturierte Keimstruktur 2 aufweist. Auf dieser Keimstruktur 2 sind Nanotubes 1 abgeschieden. Der in der Figur 6 rechts dargestellte Zustand, bei dem die Nanotubes 1 unmittelbar auf dem Substrat 3 aufliegen, wird durch den oben beschriebenen Ätzprozess erreicht, bei dem die Keimstruktur 2 durch ein Trockenätzverfahren entfernt wird.

In der in den Figuren 1 und 2 dargestellten Vorrichtung kann sowohl der Abscheideprozess als auch der durch Einleiten eines Ätzgases erfolgende Trennprozess durchgeführt werden.

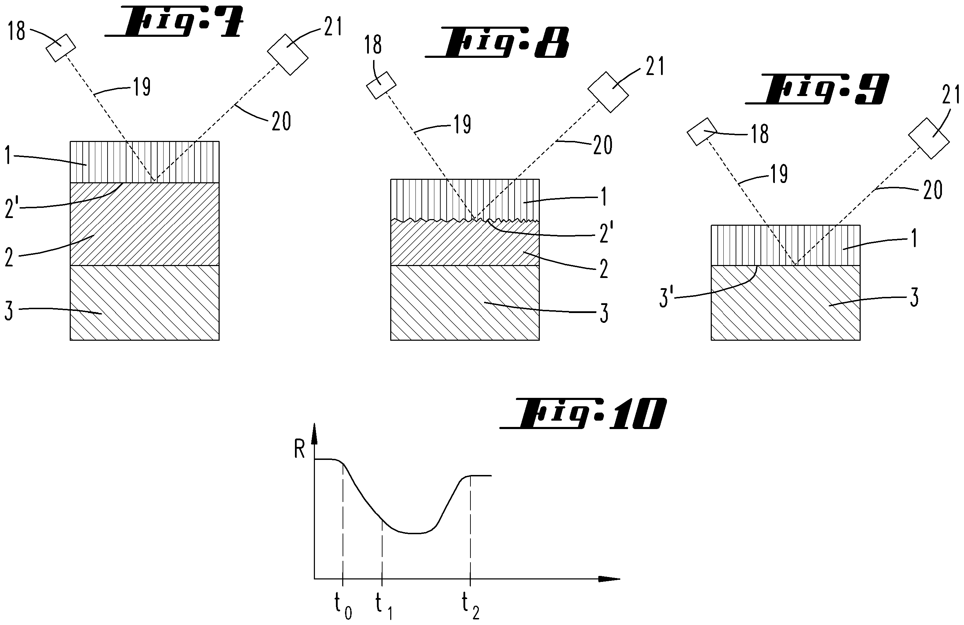

Die Figuren 7 bis 9 zeigen schematisch einen Querschnitt durch ein Objekt bestehend aus einem Substrat 3, auf welchem eine metallische Keimstruktur 2 mit einer glatten Oberfläche 2' aufgebracht ist. Auf die Oberfläche 2' wurde eine Kohlenstoffstruktur 1 entweder als Graphenschicht oder Graphenschichtenfolge oder als Nanotubes oder Nanowires abgeschieden. Die Oberfläche 2' bildet somit eine Grenzfläche zwischen der Kohlenstoffstruktur 1 und der Keimstruktur 2 aus. Mit einer Lichtquelle 18, bei der es sich um einen Halbleiterlaser handeln kann, wird ein Einfallslichtstrahl 19 erzeugt. Der Einfallslichtstrahl wird an der Grenzfläche 2' reflektiert. Der ausfallende Lichtstrahl 20 fällt in einen Detektor 21. Die Lichtquelle 18 und der Detektor 21 können in einer Prozesskammer angeordnet sein, so dass während des Ätzprozesses kontinuierlich die Änderung der Intensität des an der Grenzfläche 2 reflektierten Lichtstrahls 19, 20 gemessen werden kann. Bei einem Ausführungsbeispiel trifft der einfallende Lichtstrahl 19 in einem spitzen Winkel > 20° auf die Grenzfläche 2'. Es ist aber auch möglich, dass der einfallende Lichtstrahl 19 senkrecht zur Grenzfläche 2' auf die Grenzfläche 2' auftrifft.

Die Figur 9 zeigt das Objekt zum Zeitpunkt to zu Beginn des Ätzprozesses.

Die Figur 10 zeigt qualitativ den Verlauf der Änderung der Reflektivität an der Grenzfläche 2' während des Ätzprozesses. Zum Zeitpunkt t₀ wird der einfallende Lichtstrahl 19 an der glatten, ein hohes Reflektionsvermögen aufweisenden Oberfläche der Keimstruktur 2 reflektiert, so dass die über die Intensität des reflektierten Lichtstrahls ermittelbare Reflektivität R ein Maximum aufweist.

Während des Ätzprozesses wird Material der Keimstruktur 2 an der Grenzfläche 2' abgetragen, so dass die Grenzfläche 2' mit fortschreitendem Ätzprozess rauer wird. Das Reflektionsvermögen sinkt ab, so dass der Detektor 21 eine absinkende Intensität/Reflektivität detektiert. Dies ist in der Figur 8 zum Zeitpunkt t₁ dargestellt. Die Intensität/Reflektivität durchläuft ein Minimum und steigt anschließend wieder an, wenn nur noch Teilabschnitte der Substratoberfläche 3' mit dem Material der Keimstruktur 2 belegt sind. Die Substratoberfläche 3' besitzt ein hohes Reflektionsvermögen, da sie glatt ist. Zum Zeitpunkt t₂ erreicht die Intensität/Reflektivität ein Maximum. Sie steigt nicht weiter an. Dies ist ein Zeichen dafür, dass der Lichtstrahl 19 nur noch an der Substratoberfläche 3' reflektiert wird, die jetzt die Grenzfläche zwischen Kohlenstoffstruktur 1 und Substrat 3 bildet.

Erreicht die Intensität/Reflektivität R das auf das Minimum folgende Maximum bzw. wird festgestellt, dass die Reflektivität nicht weiter ansteigt, wird der Ätzprozess beendet.

**Bezugszeichenliste:**

| | |
|---|---|
| 1 | Kohlenstoffstruktur t₂ Zeitpunkt |
| 2 | Keimstruktur |
| 2' | Grenzfläche |
| 3 | Substrat |
| 3' | Grenzfläche |
| 4 | CVD-Reaktor |
| 5 | Suszeptor |
| 6 | Heizung |
| 7 | Prozesskammer |
| 8 | Gaseinlassorgan |
| 9 | Gasaustrittsöffnung |
| 10 | Zuleitung |
| 11 | Ätzgasquelle |
| 12 | Zuleitung |
| 13 | Inertgasleitung |
| 14 | Aktivierungsvernichter |
| 15 | Pumpe |
| 16 | Ableitung |
| 18 | Lichtquelle |
| 19 | einfallender Lichtstrahl |
| 20 | ausfallender Lichtstrahl |
| 21 | Detektor |
| R | Reflektivität |
| to | Zeitpunkt |
| t₁ | Zeitpunkt |

## Patentansprüche

1. Verfahren zum Trennen einer an einer Keimstruktur (2) abgeschiedenen Kohlenstoffstruktur (1) beispielsweise Graphene, Carbon-Nanotubes oder Halbleiter-Nanowires von der Keimstruktur (2), bestehend aus den Schritten:
- Bereitstellen einer an einer Keimstruktur (2) abgeschiedenen Kohlenstoffstruktur in einer Prozesskammer (7) eines CVD-Reaktors (4);
- Aufheizen des die Keimstruktur (2) und die Kohlenstoffstruktur (1) aufweisenden Substrates auf eine Prozesstemperatur;
- Einspeisen zumindest eines Ätzgases mit der Summenformel AOmXn, AOmXnYp oder AmXn,
wobei A aus einer Gruppe von Elementen ausgewählt ist, die S, C, N enthält,
wobei O Sauerstoff ist,
wobei X, Y verschiedene Halogene sind und
m, n, p natürliche Zahlen größer Null sind;
- Aktivierung des Ätzgases durch Zufuhr von Wärme, durch ultraviolettes Licht oder durch Plasma innerhalb der Prozesskammer (7), so dass sich das Ätzgas in erste Reaktionsprodukte vorzerlegt;
- Umwandeln der Keimstruktur (2) durch eine chemische Reaktion mit den ersten Reaktionsprodukten des Äztgases in ein zweites gasförmiges Reaktionsprodukt;
- Entfernen des gasförmigen Reaktionsproduktes aus der Prozesskammer (7) mittels eines Trägergasflusses.

2. Verfahren nach Anspruch 1, **dadurch gekennzeichnet, dass** die Keimstruktur eine Metallstruktur ist.

3. Verfahren nach Anspruch 1, **dadurch gekennzeichnet, dass** die Keimstruktur zumindest ein Element aus folgender Gruppe von Elementen enthält: Cu, Ni, Co, Fe, Ru, Ir, Ga, Gd, Mo, Mn, Ag, Au, B, Si, Ge.

4. Verfahren nach einem der vorangehenden Ansprüche, **dadurch gekennzeichnet, dass** die Keimstruktur (2) zwischen einem Substrat (3) und der Kohlenstoffstruktur (1) oder oberhalb der Kohlenstoffstruktur und in dem Substrat angeordnet ist und von Partikeln, einer Schicht auf einem Substrat (3) oder die Keimstruktur vom Substrat selbst gebildet ist.

5. Verfahren nach einem der vorangehenden Ansprüche, **dadurch gekennzeichnet, dass** das Ätzgas das Element Chlor enthält und insbesondere SOCl₂ ist.

6. Verfahren nach einem der vorangehenden Ansprüche, **dadurch gekennzeichnet, dass** das Ätzgas eine aus mehreren voneinander verschiedenen Gasen bestehende Gasmischung ist.

7. Verfahren nach einem der vorangehenden Ansprüche, **dadurch gekennzeichnet, dass** das Ätzgas in einer Ätzgasquelle (11) bereitgestellt wird, in welcher insbesondere eine Flüssigkeit verdampft wird.

8. Verfahren nach einem der vorangehenden Ansprüche, **dadurch gekennzeichnet, dass** zusammen mit dem Ätzgas ein additives Gas mit der Summenformel RX in die Prozesskammer eingespeist wird, wobei R Wasserstoff oder ein Metall ist und X ein Halogen ist.

9. Verfahren nach einem der vorangehenden Ansprüche, **dadurch gekennzeichnet, dass** der Fortschritt des Umwandelns der Keimstruktur (2) in ein gasförmiges Reaktionsprodukt durch Ermitteln der Reflektivität der Oberfläche (2') der Keimstruktur ermittelt wird, wobei insbesondere zur Ermittlung der Reflektivität eine Lichtquelle (18), die einen einfallenden Lichtstrahl (19) erzeugt, der an der Oberfläche (2') der Keimstruktur reflektiert wird und ein Detektor (21) verwendet wird, der die Intensität des reflektierten Lichtstrahls (20) misst, wobei der einfallende Lichtstrahl (19) senkrecht oder in einem Winkel zur Oberflächenerstreckung der Oberfläche (2') einfällt und/oder der Lichtstrahl kontinuierlich oder gepulst erzeugt wird.

10. Verfahren nach Anspruch 9, **dadurch gekennzeichnet, dass** das Einleiten des Ätzgases in die Prozesskammer beendet wird, wenn die vom Detektor (21) ermittelte Intensität des ausfallenden Lichtstrahls (20) nach Durchlaufen eines Minimums ein Maximum erreicht hat.

11. Verfahren nach einem oder mehreren der vorangehenden Ansprüche, **dadurch gekennzeichnet dass** vor dem Trennen der Kohlenstoffstruktur (1) von der Keimstruktur (2) die Kohlenstoffstruktur (1) in derselben Prozesskammer (7) auf der Keimstruktur (2) abgeschieden wird.

## Claims

1. A method for separating a carbon structure (1), for example graphene, carbon nanotubes or semiconductor nanowires, deposited on a seed structure (2), from the seed structure (2), consisting of the steps:
- providing a carbon structure deposited on a seed structure (2) in a process chamber (7) of a CVD reactors (4);
- heating the substrate comprising the seed structure (2) and the carbon structure (1) to a process temperature;
- injecting at least one etching gas with the molecular formula AOmXn, AOmXnYp or AmXn,
wherein A is selected from a group of elements, which includes S, C, N,
wherein O is oxygen,
wherein X, Y are different halogens and
m, n, p are natural numbers greater than zero;
activating the etching gas by supplying heat, by ultraviolet light or by plasma inside the process chamber (7) so that the etching gas decomposes into first reaction products;
- converting the seed structure (2) through a chemical reaction with the etching gas into a second gaseous reaction product;
- removing the gaseous reaction product from the process chamber (7) by means of a carrier gas flow.

2. The method according to claim 1, **characterized in that** the seed structure is a metal structure.

3. The method according to claim 1, **characterized in that** the seed structure includes at least one element from the following group of elements: Cu, Ni, Co, Fe, Ru, Ir, Ga, Gd, Mo, Mn, Ag, Au, B, Si, Ge.

4. The method according to one of the preceding claims, **characterized in that** the seed structure (2) is arranged between a substrate (3) and the carbon structure (1) or above the carbon structure and in the substrate, and is formed by particles, a layer on a substrate (3) or that the seed structure is formed by the substrate itself.

5. The method according to one of the preceding claims, **characterized in that** the etching gas includes the element chlorine and is in particular SoCl2.

6. The method according to one of the preceding claims, **characterized in that** the etching gas is a gas mixture consisting of a plurality of gases, which differ from one another.

7. The method according to one of the preceding claims, **characterized in that** the etching gas is provided in an etching gas source (11), in which in particular a liquid is evaporated.

8. The method according to one of the preceding claims, **characterized in that** an additive gas with the molecular formula RX is injected into the process chamber together with the etching gas, wherein R is hydrogen or a metal and X is a halogen.

9. The method according to one of the preceding claims, **characterized in that** the progress of the conversion of the seed structure (2) into a gaseous reaction product is determined by determining the reflectivity of the surface (2') of the seed structure, wherein a light source (18), which generates an incident light beam (19), which is reflected on the surface (2') of the seed structure, and a detector (21), which measures the intensity of the reflected light beam (20), is in particular used to determine the reflectivity, wherein the incident light beam (19) is oriented vertically or at an angle to the surface extension of the surface (2') and/or the light beam is generated continuously or in a pulsed manner.

10. The method according to claim 9, **characterized in that** the introduction of the etching gas into the process chamber is ended, when the intensity of the outgoing light beam (20) determined by the detector (21) has reached a maximum after passing through a minimum.

11. The method according to one or more of the preceding claims, **characterized in that** the carbon structure (1) is deposited on the seed structure (2) in the same process chamber (7) prior to separating the carbon structure (1) from the seed structure (2).

## Revendications

1. Procédé de séparation d'une structure de carbone (1) déposée sur une structure de germe (2), par exemple du graphène, des nanotubes de carbone ou des nanofils semi-conducteurs, de la structure de germe (2), comprenant les étapes consistant à :
- réaliser une structure de carbone déposée sur une structure de germe (2) dans une chambre de traitement (7) d'un réacteur CVD (4) ;
- chauffer le substrat présentant la structure de germe (2) et la structure de carbone (1) à une température de traitement ;
- injecter au moins un gaz d'attaque ayant la formule moléculaire AOmXn, AOmXnYp ou AmXn,
A étant choisi dans un groupe d'éléments comprenant S, C, N,
O étant l'oxygène,
X, Y étant des halogènes différents et
m, n, p sont des nombres naturels supérieurs à zéro ;
- activer le gaz d'attaque par apport de chaleur, par lumière ultraviolette ou par plasma à l'intérieur de la chambre de traitement (7) de manière que le gaz d'attaque se pré-décompose en premiers produits de réaction ;
- transformer la structure de germe (2) par une réaction chimique avec les premiers produits de réaction du gaz d'attaque en un deuxième produit de réaction gazeux ;
- éliminer le produit de réaction gazeux de la chambre de traitement (7) au moyen d'un flux de gaz porteur.

2. Procédé selon la revendication 1, **caractérisé en ce que** la structure de germe est une structure métallique.

3. Procédé selon la revendication 1, **caractérisé en ce que** la structure de germe contient au moins un élément du groupe d'éléments suivant : Cu, Ni, Co, Fe, Ru, Ir, Ga, Gd, Mo, Mn, Ag, Au, B, Si, Ge.

4. Procédé selon l'une des revendications précédentes, **caractérisé en ce que** la structure de germe (2) est agencée entre un substrat (3) et la structure de carbone (1) ou au-dessus de la structure de carbone et dans le substrat et est formée par des particules, une couche sur un substrat (3) ou la structure de germe est formée par le substrat lui-même.

5. Procédé selon l'une des revendications précédentes, **caractérisé en ce que** le gaz d'attaque contient l'élément chlore et est en particulier du SOCl₂.

6. Procédé selon l'une des revendications précédentes, **caractérisé en ce que** le gaz d'attaque est un mélange gazeux constitué de plusieurs gaz mutuellement différents.

7. Procédé selon l'une des revendications précédentes, **caractérisé en ce que** le gaz d'attaque est mis à disposition dans une source de gaz d'attaque (11) dans laquelle, notamment, un liquide est évaporé.

8. Procédé selon l'une des revendications précédentes, **caractérisé en ce que** l'on introduit dans la chambre de traitement, en même temps que le gaz d'attaque, un gaz additif ayant la formule de sommation RX, où R est l'hydrogène ou un métal et X est un halogène.

9. Procédé selon l'une des revendications précédentes, **caractérisé en ce que** la progression de la transformation de la structure de germe (2) en un produit de réaction gazeux est déterminée par la détermination de la réflectivité de la surface (2') de la structure de germe, dans lequel, en particulier, on utilise pour déterminer la réflectivité, une source de lumière (18) qui génère un faisceau lumineux incident (19) qui est réfléchi par la surface (2') de la structure de germe et un détecteur (21) qui mesure l'intensité du faisceau lumineux réfléchi (20), dans lequel le faisceau lumineux incident (19) est incident perpendiculairement ou suivant un angle par rapport à l'extension de la surface (2') et/ou le faisceau lumineux est généré de manière continue ou pulsée.

10. Procédé selon la revendication 9, **caractérisé en ce que** l'introduction du gaz d'attaque dans la chambre de traitement est terminée lorsque l'intensité du faisceau lumineux incident (20) détecté par le détecteur (21) a atteint un maximum après être passé par un minimum.

11. Procédé selon une ou plusieurs des revendications précédentes, **caractérisé en ce que**, avant de séparer la structure de carbone (1) de la structure de germe (2), la structure de carbone (1) est déposée sur la structure de germe (2) dans la même chambre de traitement (7).
